(19) Europäisches Patentamt
European Patent Office
Office européen des brevets

(11) EP 4 624 956 A1

# (12) EUROPÄISCHE PATENTANMELDUNG

(43) Veröffentlichungstag:
**01.10.2025 Patentblatt 2025/40**

(21) Anmeldenummer: **24165969.7**

(22) Anmeldetag: **25.03.2024**

(51) Internationale Patentklassifikation (IPC):
***G01R 31/3832** (2019.01)* ***G01R 31/385** (2019.01)*
***G01R 31/392** (2019.01)*

(52) Gemeinsame Patentklassifikation (CPC):
**G01R 31/3832; G01R 31/385; G01R 31/392**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft**
**80333 München (DE)**

(72) Erfinder:
- **Fischer, Michael**
**91320 Ebermannstadt (DE)**
- **Arzberger, Arno**
**96135 Stegaurach (DE)**
- **Katzer, Felix**
**90763 Fürth (DE)**
- **Radinger, Hannes**
**90459 Nürnberg (DE)**

(74) Vertreter: **Siemens Patent Attorneys**
**Postfach 22 16 34**
**80506 München (DE)**

## (54) VERFAHREN ZUM BESTIMMEN EINER EINE BATTERIEZELLE CHARAKTERISIERENDEN EIGENSCHAFT MITTELS EINER MESSVORRICHTUNG, COMPUTERPROGRAMMPRODUKT, COMPUTERLESBARES SPEICHERMEDIUM SOWIE MESSVORRICHTUNG

(57) Die Erfindung betrifft ein Verfahren zum Bestimmen einer eine Batteriezelle (12) charakterisierenden Eigenschaft, mit den Schritten: Laden der Batteriezelle (12) mit einem vorgegebenen Stromwert ($I_{HPC}$) von einem ersten Spannungswert (Vmin) zu einem zweiten Spannungswert (Vmax) mittels eines Zyklisierers (14) der Messvorrichtung (10); Bestimmen einer zugeführten Ladungsmenge (Qcharge) während des Ladens (20) mittels einer elektronischen Recheneinrichtung (16) der Messvorrichtung (10); Umpolen der Batteriezelle (12) am Zyklisierer (14) mittels einer Schalteinrichtung (18) der Messvorrichtung (10); Entladen der Batteriezelle (12) mit dem vorgegebenen Stromwert (IHPC) von dem zweiten Spannungswert (Vmax) zu dem ersten Spannungswert (Vmin) mittels des Zyklisierers (14); Bestimmen einer entnommenen Ladungsmenge (Qdischarge) während des Entladens (22) mittels der elektronischen Recheneinrichtung (14); und Bestimmen der die Batteriezelle (12) charakterisierenden Eigenschaft in Abhängigkeit von der bestimmten zugeführten Ladungsmenge (Qcharge) und der bestimmten entnommenen Ladungsmenge (Qdischarge) mittels der elektronischen Recheneinrichtung (16). Ferner betrifft die Erfindung ein Computerprogrammprodukt, ein computerlesbares Speichermedium sowie eine Messvorrichtung (10).

FIG 1
12
12
18
18
14
14
16
16
10
10

EP 4 624 956 A1

## Beschreibung

Die nachfolgende Erfindung betrifft ein Verfahren zum Bestimmen einer eine Batteriezelle charakterisierenden Eigenschaft mittels einer Messvorrichtung gemäß dem geltenden Patentanspruch 1. Ferner betrifft die Erfindung ein entsprechendes Computerprogrammprodukt, ein entsprechendes computerlesbares Speichermedium sowie eine entsprechende Messvorrichtung.

Batteriezellen lassen sich durch verschiedene Kenngrößen charakterisieren, die je nach Zelltyp, Betriebsbedingungen und Produktionsqualität jedoch deutliche Unterschiede aufweisen können. Zwei in der Praxis wichtige Kenngrößen sind dabei die Lebensdauer und die Selbstentladungsrate. Die Lebensdauer ergibt sich aus der Zellalterung, die im Wesentlichen den irreversiblen Verlust der nutzbaren Kapazität in Betriebszyklen und Zeit beschreibt. Die Selbstentladungsrate beschreibt den reversiblen Kapazitätsverlust über die Zeit. Beiden Kenngrößen ist gemein, dass sie im Normalfall nur über größere Zeitskalen zu messbaren Änderungen führen. Für praktische Untersuchungen und Bewertungen von Batteriezellen ist es hingegen wichtig, während möglichst kurzer Zeit Tests durchzuführen, welche relevante Aussagen über Kenngrößen liefern können. Aktuell werden die Zellen allerdings etwa eine Woche gelagert, um Selbstentladung anhand von Messungen vor beziehungsweise nach der Lagerung zu bestimmen. Es werden daher Methoden zur Bestimmung der Selbstentladung innerhalb von wenigen Stunden benötigt, welche dieses Vorgehen ersetzen können.

Um die Testdauer von Lebensdauer- und Selbstentladungsmessungen zu verkürzen, wird deswegen einerseits auf beschleunigte Tests zurückgegriffen, die bei höheren Temperaturen und gegebenenfalls höheren Stromstärken durchgeführt werden und so eine beschleunigte Alterung, bzw. eine Konditionierung der Zelle zur Messung der Selbstentladung zu provozieren. Allerdings stellen diese Testbedingungen dann nicht das Verhalten der Zellen unter relevanten Betriebsbedingungen dar, welches durch diese Tests beschrieben werden soll. Darüber hinaus verschlechtert sich die Energieeffizienz der Zellproduktion durch die Verwendung von hohen Temperaturen und Strömen. Aufgrund dessen, sowie der Veränderung der Batteriezellen durch diese Tests, eignet sich dieses Verfahren daher nur als stichprobenartiger Test in der Produktion und nicht zur Prüfung aller produzierten Zellen.

Andere Verfahren fokussieren sich daher auf eine erhöhte Genauigkeit in den Testmessungen, um kleine Änderungen bereits auf kurzen Zeitskalen zu quantifizieren. Im Speziellen kann hier die High Precision Coulometry (HPC)-Methode genannt werden, bei der aus der Batteriezelle entnommene beziehungsweise in ihr gespeicherte Ladungsmengen sehr genau gemessen werden. Das HPC-Verfahren misst insbesondere die genauen Ladungsmengen während der einzelnen Lade- und Entladeschritte. Damit lassen sich sowohl die Coulombic Effeciency (CE) als auch kleine Kapazitätsverluste innerhalb von wenigen Zyklen genau bestimmen. Hieraus wiederum ergeben sich beispielsweise Aussagen dann über die Selbstentladungsrate und die Lebensdauer einer Batteriezelle.

Aufgabe der vorliegenden Erfindung ist es, ein Verfahren, ein Computerprogrammprodukt, ein computerlesbares Speichermedium sowie eine Messvorrichtung zu schaffen, mittels welchen verbessert zumindest eine die Batteriezelle charakterisierende Eigenschaft bestimmt werden kann.

Diese Aufgabe wird durch ein Verfahren, ein Computerprogrammprodukt, ein computerlesbares Speichermedium sowie eine Messvorrichtung gemäß den unabhängigen Patentansprüchen gelöst. Vorteilhafte Ausgestaltungsformen sind in den Unteransprüchen angegeben.

Ein Aspekt der Erfindung betrifft ein Verfahren zum Bestimmen einer eine Batteriezelle charakterisierenden Eigenschaft mittels einer Messvorrichtung. Es erfolgt das Laden der Batteriezelle mit einem vorgegebenen Stromwert von einem ersten Spannungswert zu einem zweiten Spannungswert mittels eines Zyklisierers der Messvorrichtung. Es wird eine zugeführte Ladungsmenge während des Ladens mittels der elektronischen Recheneinrichtung der Messvorrichtung bestimmt. Es erfolgt das Umpolen der Batteriezelle am Zyklisierer mittels einer Schalteinrichtung der Messvorrichtung. Es wird die Batteriezelle mit dem vorgegebenen Stromwert von dem zweiten Spannungswert zu dem ersten Spannungswert mittels des Zyklisierers entladen. Es erfolgt das Bestimmen einer entnommenen Ladungsmenge während des Entladens mittels der elektronischen Recheneinrichtung und das Bestimmen der die Batteriezelle charakterisierenden Eigenschaft in Abhängigkeit von der bestimmten zugeführten Ladungsmenge und der bestimmten entnommenen Ladungsmenge mittels der elektronischen Recheneinrichtung.

Insbesondere können somit systematische Messfehler bei der Strommessung des Zyklisierers, welcher auch als Potentiostat bezeichnet wird, die zu Drifts in den ermittelten Ladungsmengen führen, berücksichtigt werden. Ein systematischer Strommessfehler (Offset) von beispielsweise 2 mA würde dazu führen, dass wenn der Zyklisierer bei einem Ladevorgang einen Wert von 1 A einstellt beziehungsweise misst, bei der Batteriezelle tatsächlich nur 0,998 A angelegt werden. Umgekehrt würde bei einem Entladevorgang, der am Zyklisierer auf - 1 A eingestellt wird, entsprechend - 1,002 A an der Batteriezelle anliegen. Algorithmen können zwar bestimmte Drifts von Ladungsmengen um den systematischen Fehler korrigieren, was beispielsweise eine genauere Messung des Kapazitätsverlusts erlaubt. Allerdings lassen sich systematische Strommessfehler bisher nicht von Effekten der Selbstentladung unterscheiden, so dass diese Korrekturen keine genaue Messung der Coulombic Effeciency (CE) beziehungsweise der Selbstentladungsrate ermöglichen. Es werden also andere Methoden benötigt, um die systematischen Strommessfehler von der Selbstentladung zu trennen, um somit eine genauere Messung der Selbstentladungsrate zu ermöglichen.

Insbesondere ist nun vorgesehen, dass die Batteriezelle im ersten Ladeabschnitt bis zum ersten Spannungswert geladen wird. Nach Erreichen dieses Spannungswerts wird der Stromfluss insbesondere kurz gestoppt und die Schalteinrichtung schaltet um, so dass die Kontaktierung zwischen Zyklisierer und Batteriezelle vertauscht wird. Dadurch messen die stromführenden Leitungen am Zyklisierer nun die Spannung negativ. Bei bisherigen Verfahren gemäß dem Stand der Technik wurde für den nun folgenden Entladeabschnitt ein negativer Stromfluss gewählt, um die Zelle bis zur Spannung mit dem zweiten Spannungswert zu entladen. Bei dem hier vorgestellten Verfahren wird durch die neue Verschaltung der Entladevorgang jedoch anders realisiert. Es wird nun mit der gleichen Stromstärke, wie beim Ladevorgang, weiter "geladen", wodurch sich die messbare Spannung von dem negativen zweiten Spannungswert auf den negativen ersten Spannungswert erhöht. An dieser Stelle wird der Vorgang beispielsweise wieder kurz unterbrochen und die Schalteinrichtung schaltet wieder auf den ursprünglichen Zustand zurück. Die vom Zyklisierer messbare Spannung ändert sich dadurch von dem negativen ersten Spannungswert auf den positiven ersten Spannungswert. Damit ist der Zyklus abgeschlossen und die folgenden Zyklen können auf die gleiche Weise fortgeführt werden. Die beschriebenen messbaren Spannungsverläufe an der Batteriezelle selbst bleiben dabei verglichen mit bekannten Verfahren unverändert und verlaufen insbesondere zwischen dem ersten Spannungswert und dem zweiten Spannungswert.

Insbesondere können somit beim Stand der Technik systematische Messfehler der Stromstärke am Zyklisierer nicht von der Selbstentladung der Batteriezelle unterschieden werden. Hierdurch können Selbstentladungsraten nur dann mit einem entsprechenden Verfahren gemessen werden, wenn der Messfehler deutlich geringer als die Selbstentladung ist, was bei qualitativ hochwertigen Batteriezellen in der Praxis aber schwierig und nur mit sehr teurer Elektronik zu realisieren ist. Mit der hier vorgestellten Umpolung zwischen den Lade- und Entladevorgängen lassen sich Selbstentladungsraten und Messfehler voneinander trennen. Hier geht der systematische Strommessfehler nur mit der Differenz der Lade- und Entladezeiten ein, wohingegen sich die Selbstentladung über die Summe beider Zeiten äußert. Es kann insbesondere davon ausgegangen werden, dass der Einfluss des Messfehlers dadurch um einen Faktor von $10^3$ reduziert werden kann.

Die Bestimmung des Verlusts an reversibler Kapazität pro Zyklus kann dann insbesondere über die Berechnung der Ladungsmengen erfolgen und unterscheidet sich nicht zwischen dem bisherigen und dem vorgestellten Verfahren. Der Verlust an reversibler Kapazität innerhalb eines Zyklus, der sich über den Unterschied der Ladungsmengen aufeinanderfolgender Zyklen äußert, kann anhand des Verlusts pro Zyklus abgeschätzt werden. In der Praxis liegt sowohl der Kapazitätsverlust als auch die Selbstentladung pro Zyklus bei etwa 0,01 Prozent. Ein Vergleich dieses Werts mit der Messfehler-überlagerten Coulombic Effeciency (CE) zeigt die Notwendigkeit der hier vorgestellten Erfindung, falls das Verfahren zur Bestimmung der Selbstentladung genutzt werden soll.

Hierbei ist insbesondere wichtig, dass durch das Umschalten in den negativen Spannungsbereich oder anderweitig im Prozess, keine Änderungen im Zyklisierer auftreten, welche den systematischen Messfehler verändern würden, da dieser sonst nicht, wie hier vorgestellt, vollständig korrigiert werden kann. Zu beachten ist, dass nur die stromführenden Leitungen umgepolt werden müssen. Falls separate Leitungen zur Spannungsmessung verwendet werden, können diese auch ohne Umpolung verwendet werden.

Gemäß einer vorteilhaften Ausgestaltungsform wird als die charakterisierende Eigenschaft eine Selbstentladungsrate der Batteriezelle bestimmt. Insbesondere Batteriezellen weisen die so genannte Selbstentladungsrate auf, welche dazu führt, dass ohne äußeren Einfluss dennoch eine Entladung der Batteriezelle aufzufinden ist. Diese Selbstentladungsrate ist wiederum eine spezifische charakterisierende Eigenschaft einer spezifischen Batteriezelle. Diese dient insbesondere zur Qualitätsbestimmung der Batteriezelle. Es ist nun möglich, dass die Selbstentladungsrate zuverlässig und hochpräzise auf Basis des vorgestellten Verfahrens bestimmt werden kann.

Eine weitere vorteilhafte Ausgestaltungsform sieht vor, dass als die charakterisierende Eigenschaft eine Lebensdauer der Batteriezelle bestimmt wird. Insbesondere die Lebensdauer der Batteriezelle ist ebenfalls eine wichtige Kenngröße einer spezifischen Batteriezelle und dient insbesondere zum Bestimmen der Qualität der Batteriezelle. Dabei kann zusätzlich oder ergänzend als die charakterisierende Eigenschaft ein Kapazitätsverlust pro Zyklus der Batteriezelle bestimmt werden. Auf Basis des Kapazitätsverlusts können beispielsweise die Lebensdauer und/oder die Selbstentladungsrate bestimmt werden. Die Bestimmung des Kapazitätsverlusts benötigt noch mindestens eine weitere Ladungsmenge eines folgenden Zyklus. Somit werden mehrere $Q_{charge}$ (zugeführte Ladungsmenge) und $Q_{discharge}$ (entnommene Ladungsmenge) aus mehreren Zyklen benötigt, da hier beispielsweise der Unterschied von $Q_{discharge}$ aus zwei aufeinanderfolgenden Zyklen verglichen wird. Somit kann mittels des vorgeschlagenen Verfahrens die Lebensdauer der Batteriezelle bestimmt werden.

Es hat sich weiterhin als vorteilhaft erwiesen, wenn die Schalteinrichtung als mechanischer Schalter bereitgestellt wird. Insbesondere kann somit zuverlässig die mechanische Schalteinrichtung eine erste Position und eine zweite Position aufweisen. In der ersten Position kann beispielsweise eine Normalpolung bereitgestellt werden und in der zweiten Position kann eine Umpolung bereitgestellt werden. Somit kann auf sichere Art und Weise die Umpolung realisiert werden.

Es hat sich weiter als vorteilhaft erwiesen, wenn die Schalteinrichtung als elektronischer Schalter bereitgestellt wird. Insbesondere elektronische Schalter können auf einfache Art und Weise angesteuert werden, so dass ein zuverlässiger Schaltprozess realisiert werden kann.

Ebenfalls vorteilhaft ist, wenn während der Umpolung die Schalteinrichtung als halbleiterbasierter Schalter bereitgestellt wird. Insbesondere kann die Schalteinrichtung beispielsweise als MOSFET bereitgestellt werden. Dabei handelt es sich insbesondere um sehr kleine Bauteile, welche sehr zuverlässig arbeiten können. Somit kann auf Basis der halbleiterbasierten Schalter eine zuverlässige Umpolung im Zyklisierer bereitgestellt werden.

Ferner hat es sich als vorteilhaft erwiesen, wenn während der Umpolung der Ladevorgang und/oder der Entladevorgang aktiv pausiert wird. Mit anderen Worten ist vorgesehen, dass nach dem Ladevorgang auf den zweiten Spannungswert kein Stromfluss des Zyklisierers zu verzeichnen ist. Es findet dann, insbesondere ohne Stromfluss, die Umpolung statt. Erst danach wird wieder der entsprechende vorgegebene Stromwert angelegt, um die Batteriezelle zu entladen. Nach dem Entladevorgang auf den ersten Spannungswert wird wieder kurzzeitig der Stromfluss komplett aktiv unterbrochen, und die Umpolung wird ohne Stromfluss entsprechend durchgeführt. Somit kann zuverlässig eine Umpolung realisiert werden. Des Weiteren sind entsprechende Schaltverluste nicht zu verzeichnen, da kein Stromfluss und somit keine Abweichungen des Stromflusses an der Batteriezelle zu verzeichnen sind. Somit kann sehr genau die charakterisierende Eigenschaft bestimmt werden.

In einer weiteren vorteilhaften Ausgestaltungsform ist vorgesehen, dass das Verfahren als Hochpräzisionscoulometrie-Verfahren ausgeführt wird. Dabei handelt es sich insbesondere um das bereits erwähnte High Precision Coulometry (HPC)-Verfahren. Das HPC-Verfahren misst die genauen Ladungsmengen während der einzelnen Lade- und Entladeschritte. Insbesondere verfolgt dabei das HPC-Verfahren entsprechende Testzyklen, bei denen die Batteriezelle zwischen zwei definierten Zuständen, insbesondere beschrieben durch eine Maximalspannung und eine Minimalspannung mit einer definierten Stromstärke zyklisiert wird. Die Dauer der einzelnen Lade- und Entladeschritte $t_{charge}$ und $t_{discharge}$ hängen dabei von den Eigenschaften der getesteten Batteriezelle ab. Auf Basis des HPC-Verfahrens kann somit hochpräzise die Coulombic Effeciency entsprechend bestimmt werden und auf Basis dessen wiederum zuverlässig die charakterisierende Eingabe der Batteriezelle bestimmt werden.

Es hat sich weiterhin als vorteilhaft erwiesen, wenn der erste Spannungswert als ein minimaler Spannungswert für die Batteriezelle vorgegeben wird und der zweite Spannungswert als ein maximaler Spannungswert für die Batteriezelle vorgegeben wird. Insbesondere ist unter maximalem Spannungswert zu verstehen, dass die Batteriezelle in einem Betriebsfenster mit unterschiedlichen Spannungen betrieben wird. Diese Spannungswerte können dabei vorgegebene Spannungswerte sein. Insbesondere weist beispielsweise beim ersten Spannungswert, also beim minimalen Spannungswert, die Batteriezelle den niedrigsten Ladungszustand auf. Beim zweiten Spannungswert, insbesondere beim maximalen Spannungswert, weist die Batteriezelle wiederum den höchsten Ladezustand auf. Hierbei handelt es sich insbesondere um im Wesentlichen optimale Betriebsfenster für die Batteriezelle, welche beispielsweise durch entsprechende Datenblätter vorgegeben sein kann. Somit kann zuverlässig die charakterisierende Eigenschaft bestimmt werden.

Ebenfalls vorteilhaft ist, wenn das Verfahren nach dem Entladen wiederholt wird. Insbesondere wird eine Vielzahl von Testzyklen durchgeführt. Die Testzyklen sind dabei insbesondere nacheinander durchzuführen, um somit zuverlässig die Eigenschaft der Batteriezelle bestimmen zu können. Mit anderen Worten erfolgt nach einem Entladevorgang zumindest ein erneuter Ladevorgang.

Weiterhin vorteilhaft ist, wenn die zugeführte Ladungsmenge auf Basis einer Ladedauer von dem ersten Spannungswert zu dem zweiten Spannungswert bestimmt wird. Insbesondere kann somit die Ladungsmenge auf Basis der Ladedauer bestimmt werden.

Weiterhin vorteilhaft ist, wenn die entnommene Ladungsmenge auf Basis einer Entladedauer von dem zweiten Spannungswert zu dem ersten Spannungswert bestimmt wird. Somit kann zuverlässig die entnommene Ladungsmenge bestimmt werden.

Bei dem vorgestellten Verfahren handelt es sich zumindest in Teilen um ein computerimplementiertes Verfahren. Daher betrifft ein weiterer Aspekt der Erfindung ein Computerprogrammprodukt mit Programmcodemitteln, welche eine elektronische Recheneinrichtung dazu veranlassen, wenn die Programmcodemittel von der elektronischen Recheneinrichtung abgearbeitet werden, ein Verfahren nach dem vorhergehenden Aspekt durchzuführen.

Weiterhin betrifft die Erfindung daher auch ein computerlesbares Speichermedium mit dem Computerprogrammprodukt nach dem vorhergehenden Aspekt.

Ferner betrifft die Erfindung auch eine Messvorrichtung zum Bestimmen einer eine Batteriezelle charakterisierenden Eigenschaft, mit zumindest einem Zyklisierer, einer elektronischen Recheneinrichtung und einer Schalteinrichtung, wobei die Messvorrichtung zum Durchführen eines Verfahrens nach dem vorhergehenden Aspekt ausgebildet ist. Insbesondere wird das Verfahren mittels der Messvorrichtung durchgeführt.

Vorteilhafte Ausgestaltungsformen des Verfahrens sind als vorteilhafte Ausgestaltungsformen des Computerprogrammprodukts, des computerlesbaren Speichermediums sowie der Messvorrichtung anzusehen. Die Messvorrichtung weist hierzu insbesondere gegenständliche Merkmale auf, um entsprechende Verfahrensschritte durchführen zu können.

Unter einer Recheneinheit/elektronische Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Für Anwendungsfälle oder Anwendungssituationen, die sich bei einem erfindungsgemäßen Verfahren ergeben können und die hierin nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:

Fig. 1 ein schematisches Blockschaltbild gemäß einer Ausführungsform einer Messvorrichtung; und

Fig. 2 ein schematisches Zeitdiagramm gemäß einer Ausführungsform des Verfahrens.

Die Erfindung wird im Folgenden anhand konkreter Ausführungsbeispiele und zugehöriger schematischer Zeichnungen näher erläutert. In den Figuren können gleiche oder

funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

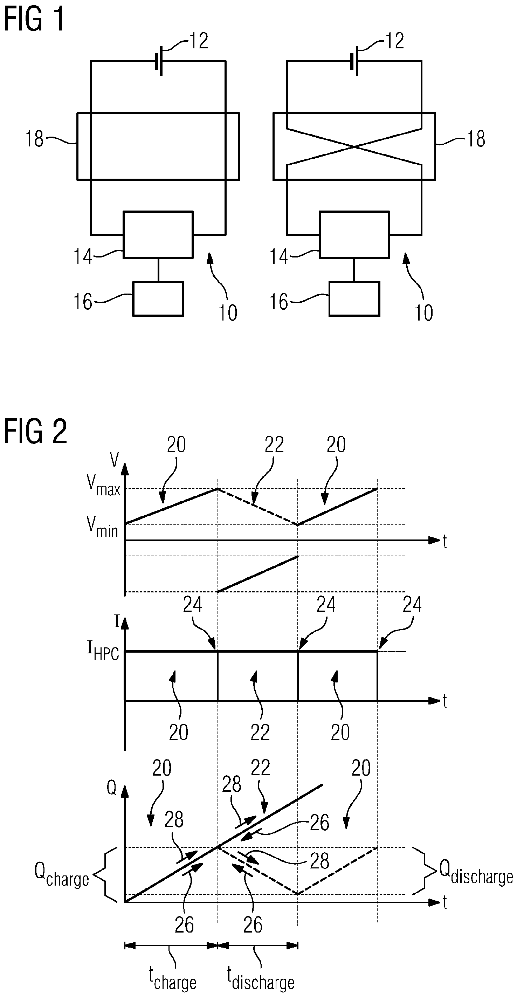

Fig. 1 zeigt eine schematische Ansicht einer Ausführungsform einer Messvorrichtung 10. Die Messvorrichtung 10 ist vorliegend in zwei unterschiedlichen Zuständen gezeigt. Die Messvorrichtung 10 ist zum Bestimmen einer eine Batteriezelle 12 charakterisierenden Eigenschaft ausgebildet. Hierzu weist die Messvorrichtung 10 zumindest einen Zyklisierer 14, eine elektronische Recheneinrichtung 16 sowie eine Schalteinrichtung 18 auf. Die elektronische Recheneinrichtung 16 kann dabei insbesondere zum Auswerten eines Messvorgangs für die Batteriezelle 12 ausgebildet sein. Ferner kann die elektronische Recheneinrichtung 16 auch zum Ansteuern des Zyklisierers 14 und zum Ansteuern der Schalteinrichtung 18 ausgebildet sein. Mit anderen Worten können über die elektronische Recheneinrichtung 16 entsprechende Steuersignale für den Zyklisierer 14 sowie für die Schalteinrichtung 18 erzeugt werden. Ferner können insbesondere elektrische Werte von dem Zyklisierer 14 an die elektronische Recheneinrichtung 16 übertragen werden, wobei auf Basis dessen wiederum eine entsprechende Auswertung durchgeführt werden kann.

Die Fig. 1 zeigt auf der linken Seite beispielsweise die Messvorrichtung 10 während eines Ladevorgangs der Batteriezelle 12 und auf der rechten Seite ist insbesondere eine Umpolung über die Schalteinrichtung 18 gezeigt, wobei dies insbesondere dann einem Entladevorgang der Batteriezelle 12 entspricht.

Fig. 2 zeigt ein schematisches Diagramm gemäß einer Ausführungsform des Verfahrens. Dabei sind insbesondere drei unterschiedliche Diagramme gezeigt, im oberen Teil ist insbesondere eine Spannung V dargestellt, im mittleren Teil ein Strom I und im unteren Teil eine entsprechende Ladungsmenge Q. Auf der Abszisse ist in allen drei einzelnen Diagrammen die Zeit t aufgetragen. Insbesondere sind diese drei Diagramme derart untereinander dargestellt, dass die Zeiten entsprechend übereinstimmen.

Im oberen Teil des Diagramms ist, wie bereits erwähnt, die Spannung V aufgetragen. Im mittleren Diagramm ist ein Stromwert I aufgetragen und im unteren Diagramm die Ladungsmenge Q.

Insbesondere stellt somit die Fig. 2 das Verfahren zum Bestimmen der charakterisierenden Eigenschaft der Batteriezelle 12 dar. Es erfolgt das Laden 20 der Batteriezelle 12 mit einem vorgegebenen Stromwert $I_{HPC}$ von einem ersten Spannungswert $V_{min}$ zu einem zweiten Spannungswert $V_{max}$ mittels des Zyklisierers 14. Es wird die zugeführte Ladungsmenge $Q_{charge}$ während des Ladens 20 mittels der elektronischen Recheneinrichtung 16 bestimmt. Es erfolgt das Umpolen der Batteriezelle 12 am Zyklisierer 14 mittels der Schalteinrichtung 18. Es erfolgt ein Entladen 22 der Batteriezelle 12 mit dem vorgegebenen Stromwert $I_{HPC}$ von dem zweiten Spannungswert $V_{max}$ zu dem ersten Spannungswert $V_{min}$ mittels des Zyklisierers 14. Es wird eine entnommene Ladungsmenge $Q_{discharge}$ während des Entladens 22 mittels der elektronischen Recheneinrichtung 16 bestimmt und es erfolgt das Bestimmen der die Batteriezelle 12 charakterisierenden Eigenschaft in Abhängigkeit von der bestimmten zugeführten Ladungsmenge $Q_{charge}$ und der bestimmten entnommenen Ladungsmenge $Q_{discharge}$ mittels der elektronischen Recheneinrichtung 16.

Insbesondere kann dabei vorgesehen sein, dass als die charakterisierende Eigenschaft eine Selbstentladungsrate der Batteriezelle 12 bestimmt wird. Ferner kann als charakterisierende Eigenschaft eine Lebensdauer, bzw. Kapazitätsverlust pro im Experiment angewendeten Lade/Entladezyklus der Batteriezelle 12 bestimmt werden.

Es kann weiterhin vorgesehen sein, dass die Schalteinrichtung 18 als mechanischer Schalter bereitgestellt wird und/oder die Schalteinrichtung 18 als elektronischer Schalter bereitgestellt wird und/oder die Schalteinrichtung 18 als halbleiterbasierter Schalter bereitgestellt wird.

Des Weiteren ist insbesondere im mittleren Teil der Fig. 2 dargestellt, dass während der Umpolung der Ladevorgang und/oder der Entladevorgang aktiv pausiert wird. Insbesondere ist in der Fig. 2 dafür eine aktive Pause 24 dargestellt. Insbesondere wird dabei der vorgegebene Stromwert $I_{HPC}$ nach dem Ladevorgang kurz unterbrochen und auf Null gesetzt und umgepolt. Es erfolgt dann erst, insbesondere nach der aktiven Pause 24, wiederum das Anlegen des vorgegebenen Stromwerts $I_{HPC}$.

Dabei zeigt die Fig. 2 insbesondere, dass das Verfahren während eines Hochpräzisionscoulometrie-Verfahrens (HPC) durchgeführt wird.

Des Weiteren zeigt die Fig. 2, dass der erste Spannungswert $V_{min}$ als ein minimaler Spannungswert für die Batteriezelle 12 vorgegeben wird, und der zweite Spannungswert $V_{max}$ als ein maximaler Spannungswert für die Batteriezelle 12 vorgegeben wird.

Des Weiteren zeigt die Fig. 2, dass das Verfahren nach dem Entladen insbesondere wiederholt wird.

Ebenfalls ist insbesondere vorgesehen, dass die zugeführte Ladungsmenge $Q_{charge}$ auf Basis einer Ladedauer $t_{charge}$ von dem ersten Spannungswert $V_{min}$ zum zweiten Spannungswert $V_{max}$ bestimmt wird. Des Weiteren ist vorgesehen, dass die entnommene Ladungsmenge $Q_{discharge}$ auf Basis einer Entladedauer $t_{discharge}$ von dem zweiten Spannungswert $V_{max}$ zu dem ersten Spannungswert $V_{min}$ bestimmt wird.

Insbesondere zeigt somit die Fig. 2, dass die Verwendung der Schalteinrichtung 18, die die Verbindung zwischen Zyklisierer 14 und der Batteriezelle 12 darstellt, nach jedem Ladebeziehungsweise Entladeabschnitt umgepolt wird. Zu Beginn ist die Schalteinrichtung 18 so geschalten, dass der Zyklisierer 14 die Batteriezelle 12 wie in einem normalen HPC-Verfahren kontaktiert.

Nun wird die Batteriezelle im ersten Ladeabschnitt bis zur Spannung $V_{max}$ geladen. Nach Erreichen dieser Spannung wird der Stromfluss kurz gestoppt und die Schalteinrichtung 18 schaltet um, so dass die Kontaktierung zwischen dem Zyklisierer 14 und der Batteriezelle 12 vertauscht wird. Dadurch misst der Zyklisierer 14 nun die Spannung $-V_{max}$. Beim Verfahren gemäß dem Stand der Technik wurde im nun folgenden Entladeabschnitt ein negativer Stromfluss gewählt, um die Batteriezelle 12 mit der Spannung $V_{min}$ zu entladen. Beim hier vorgestellten Verfahren wird durch die neue Verschaltung der Entladevorgang jedoch anders realisiert. Es wird nun mit der gleichen Stromstärke wie beim Ladevorgang weitergeladen, wodurch die messbare Spannung von $-V_{max}$ auf $-V_{min}$ erhöht wird. An dieser Stelle wird der Vorgang wieder kurz unterbrochen und die Schalteinrichtung 18 schaltet wieder auf den ursprünglichen Zustand zurück. Die vom Zyklisierer 14 messbare Spannung ändert sich dadurch von $-V_{min}$ auf $V_{min}$. Damit ist der Zyklus abgeschlossen und die folgenden Zyklen können auf die gleiche Weise fortgeführt werden. Der Spannungsverlauf am Zyklisierer 14 ist insbesondere im oberen Teil der Fig. 2 dargestellt. Der Spannungsverlauf 12 einer Batteriezelle 12 selbst bleibt verglichen mit dem bisherigen HPC-Verfahren unverändert und verläuft zwischen $V_{min}$ und $V_{max}$. Der mittlere Teil der Fig. 2 zeigt insbesondere die am Zyklisierer 14, insbesondere durchgezogene Linie, beziehungsweise an der Batteriezelle 12 die gestrichelte Linie messbare Stromstärke als Folge des hier vorgestellten Schaltvorgangs für die Batteriezelle 12.

Im unteren Teil der Fig. 2 ist wiederum insbesondere dargestellt, dass der Messfehler beim vorgestellten Verfahren nur mit der Differenz aus Lade- und Entladezeiten einhergeht. Die entsprechende Selbstentladungsrate hingegen äußert sich weiterhin mit der Summe dieser beiden. Im unteren Teil sind dabei insbesondere die gemessenen und berechneten Ladungsmengen dargestellt.

Die im Idealfall an der Batteriezelle 12 messbare Ladungsmenge Q während eines Ladevorgangs $Q_{Charge,Cell}$ setzt sich aus der aktuell verfügbaren reversiblen Kapazität $Q_{Charge,Capacity}$ und der Selbstentladung während des Ladevorgangs zusammen. Die Selbstentladung ergibt sich dabei als Produkt aus einer zellspezifischen Selbstentladungsrate $I_{Self\text{-}Discharge}$ und der Zeit des Ladevorgangs $t_{Charge}$:

$$(1)\quad Q_{Charge,Cell} = Q_{Charge,Capacity} + I_{Self-Discharge} \times t_{Charge}$$

Analog ergibt sich die an der Zelle messbare Ladungsmenge $Q_{Discharge,Cell}$ während eines Entladevorgangs der Dauer $t_{Discharge}$. Hier ist jedoch zu beachten, dass die reversible Ladungsmenge $Q_{Discharge,Capacity}$ zur Verringerung des Gesamt-Ladungsdurchsatzes beiträgt. Entsprechend wird im Fall der Entladung der Betrag der messbaren Ladungsmenge durch die Selbstentladung reduziert, wohingegen der Betrag beim Laden durch die Selbstentladung erhöht wurde.

$$(2)\quad Q_{Discharge,Cell} = -Q_{Discharge,Capacity} + I_{Self-Discharge} \times t_{Discharge}$$

Die reversiblen Kapazitäten $Q_{Charge,Capacity}$ und $Q_{Discharge,Capacity}$ verringern sich dabei durch Alterung/Degradation der Batteriezelle 12 während deren Nutzung.

Die im bisherigen HPC-Verfahren tatsächlich durch den Zyklisierer 14 messbaren Ladungsmengen $Q_{charge}$ bzw. $Q_{Discharge}$ werden aber zusätzlich durch den systematischen Messfehler der Strommessung beeinflusst. Dessen Einfluss auf die Ladungsmenge ergibt sich ebenfalls als Produkt des Messfehlers $I_{Error}$ mit der entsprechenden Dauer des Lade- bzw. Entladevorgangs:

$$(3)\quad Q_{Charge} = Q_{Charge,Cell} + I_{Error} \times t_{Charge}$$

$$(4)\quad Q_{Discharge} = Q_{Discharge,Cell} + I_{Error} \times t_{Discharge}$$

Die Summe der tatsächlich messbaren Ladungsmengen beim Lade- und Entladevorgang (bzw. der Gesamtdurchsatz an Ladungsmenge am Zyklisieer 14) ergibt sich entsprechend zu:

$$Q_{Charge} + Q_{Discharge} = Q_{Charge.Capacity} - Q_{Discharge.Capacity} + [I_{Self\text{-}Discharge} + I_{Error}] \times [t_{Charge} + t_{Discharge}] \quad (5)$$

Hieraus sieht man insbesondere, dass sich die Selbstentladung und der Messfehler mit der gleichen zeitlichen Abhängigkeit im Ladungsdurchsatz äußern und entsprechend im bisherigen Messverfahren nicht voneinander unterschieden werden können.

Durch die hier vorgestellte Umpolung der Kontaktierung zwischen den Lade- und Entladevorgängen ändert sich das Verhalten jedoch. Im Beispiel wurde die Kontaktierung während des Entladevorgangs vertauscht, wodurch sich auch das Vorzeichen vertauscht, mit dem die Ladungsmenge der Batteriezelle 12 in die Messung eingeht. Der Messfehler am Zyklisierer 14 selbst bleibt aber unverändert. Die im hier vorgestellten Verfahren messbare Ladungsmenge $Q_{Discharge,Reversal}$ ergibt sich anstelle von (4) jetzt zu:

$$(6)\quad Q_{Discharge,Reversal} = -Q_{Discharge,Cell} + I_{Error} \times t_{Discharge}$$

Um den Ladungsdurchsatz korrekt zu bestimmen, muss diese Ladungsmenge (6) anschließend von der Ladungsmenge des Ladevorgangs (3) abgezogen werden:

$$Q_{Charge} + Q_{Discharge.Reversal} = Q_{Charge.Capacity} - Q_{Discharge.Capacity} + I_{Self\text{-}Discharge} \times [t_{Charge} + t_{Discharge}] + I_{Error} \times [t_{Charge} - t_{Discharge}] \quad (7)$$

Hier sieht man, dass der Messfehler beim vorgestellten Verfahren nur mit der Differenz aus Lade- und Entladezeiten eingeht. Die Selbstentladungsrate hingegen äußert sich weiterhin mit der Summe dieser beiden Zeiten.

Die am Zyklisierer 14 gemessenen Ladungsmengen als Folge des hier vorgestellten Schaltvorgangs und des daraus berechneten Ladungsdurchsatzes, sind insbesondere als gestrichelte Linie dargestellt, für die entsprechenden Zyklen. Durch die Umpolung tritt auch während der Entladevorgänge der Batteriezelle 12 ein positiver messbarer Zuwachs an Ladungsmenge auf, welcher jedoch entsprechend mit negativem Vorzeichen verrechnet werden kann. Dabei werden die Pfeile 16 den Einfluss der Selbstentladung darstellen, welche für die berechneten Ladungsdurchsatz, insbesondere durch die gestrichelte Linie dargestellt, dem Verhalten gemäß dem HPC-Verfahren entspricht. Die Pfeile 28 stellen den systematischen Strommessfehler am Zyklisierer 14 dar, welcher für die gemessene Ladungsmenge stets konstant bleibt und sein Vorzeichen nicht ändert. Beim berechneten Ladungsdurchsatz, insbesondere die gestrichelte Linie, geht dieser nun mit umgekehrten Vorzeichen ein, im Gegensatz zum ursprünglichen HPC-Verfahren.

Bezugszeichenliste

| | |
|---|---|
| 10 | Messvorrichtung |
| 12 | Batteriezelle |
| 14 | Zyklisierer |
| 16 | elektronische Recheneinrichtung |
| 18 | Schalteinrichtung |
| 20 | Laden |
| 22 | Entladen |
| 24 | Pause |
| 26 | Pfeil |
| 28 | Pfeil |
| $t$ | Zeit |
| $t_{charge}$ | Ladedauer |
| $t_{discharge}$ | Entladedauer |
| $V_{min}$ | erster Spannungswert |
| $V_{max}$ | zweiter Spannungswert |
| $I_{HPC}$ | vorgegebener Stromwert |
| $Q_{charge}$ | zugeführte Ladungsmenge |
| $Q_{discharge}$ | entnommene Ladungsmenge |

**Patentansprüche**

**1.** Verfahren zum Bestimmen einer eine Batteriezelle (12) charakterisierenden Eigenschaft mittels einer Messvorrichtung (10), mit den Schritten:

- Laden der Batteriezelle (12) mit einem vorgegebenen Stromwert ($I_{HPC}$) von einem ersten Spannungswert ($V_{min}$) zu einem zweiten Spannungswert ($V_{max}$) mittels eines Zyklisierers (14) der Messvorrichtung (10);
- Bestimmen von zumindest einer zugeführten Ladungsmenge ($Q_{charge}$) während des Ladens (20) mittels einer elektronischen Recheneinrichtung (16) der Messvorrichtung (10);
- Umpolen der Batteriezelle (12) am Zyklisierer (14) mittels einer Schalteinrichtung (18) der Messvorrichtung (10);
- Entladen der Batteriezelle (12) mit dem vorgegebenen Stromwert ($I_{HPC}$) von dem zweiten Spannungswert ($V_{max}$) zu dem ersten Spannungswert ($V_{min}$) mittels des Zyklisierers (14);
- Bestimmen von zumindest einer entnommenen Ladungsmenge ($Q_{discharge}$) während des Entladens (22) mittels der elektronischen Recheneinrichtung (14); und
- Bestimmen der die Batteriezelle (12) charakterisierenden Eigenschaft in Abhängigkeit von der bestimmten zugeführten Ladungsmenge ($Q_{charge}$) und der bestimmten entnommenen Ladungsmenge ($Q_{discharge}$) mittels der elektronischen Recheneinrichtung (16).

**2.** Verfahren nach Anspruch 1, **dadurch gekennzeichnet, dass** als die charakterisierende Eigenschaft eine Selbstentladungsrate der Batteriezelle (12) bestimmt wird.

**3.** Verfahren nach Anspruch 1 oder 2, **dadurch gekennzeichnet, dass** als die charakterisierende Eigenschaft eine Lebensdauer der Batteriezelle (12) bestimmt wird.

**4.** Verfahren nach einem der vorhergehenden Ansprüche, **dadurch gekennzeichnet, dass** die Schalteinrichtung (18) als mechanischer Schalter bereitgestellt wird.

**5.** Verfahren nach einem der vorhergehenden Ansprüche, **dadurch gekennzeichnet, dass** die Schalteinrichtung (18) als elektronischer Schalter bereitgestellt wird.

6. Verfahren nach einem der vorhergehenden Ansprüche, **dadurch gekennzeichnet, dass** die Schalteinrichtung (18) als halbleiterbasierter Schalter bereitgestellt wird.

7. Verfahren nach einem der vorhergehenden Ansprüche, **dadurch gekennzeichnet, dass** während der Umpolung der Ladevorgang und/oder der Entladevorgang aktiv pausiert wird.

8. Verfahren nach einem der vorhergehenden Ansprüche, **dadurch gekennzeichnet, dass** das Verfahren während eines Hochpräzisionscoulometrie-Verfahrens durchgeführt wird.

9. Verfahren nach einem der vorhergehenden Ansprüche, **dadurch gekennzeichnet, dass** der erste Spannungswert ($V_{min}$) als ein minimaler Spannungswert für die Batteriezelle (12) vorgegeben wird und der zweite Spannungswert ($V_{max}$) als ein maximaler Spannungswert für die Batteriezelle (12) vorgegeben wird.

10. Verfahren nach einem der vorhergehenden Ansprüche, **dadurch gekennzeichnet, dass** das Verfahren nach dem Entladen wiederholt wird.

11. Verfahren nach einem der vorhergehenden Ansprüche, **dadurch gekennzeichnet, dass** die zugeführte Ladungsmenge ($Q_{charge}$) auf Basis einer Ladedauer ($t_{charge}$) von dem ersten Spannungswert ($V_{min}$) zu dem zweiten Spannungswert ($V_{max}$) bestimmt wird.

12. Verfahren nach einem der vorhergehenden Ansprüche, **dadurch gekennzeichnet, dass** die entnommene Ladungsmenge ($Q_{discharge}$) auf Basis einer Entladedauer ($t_{discharge}$) von dem zweiten Spannungswert ($V_{max}$) zu dem ersten Spannungswert ($V_{min}$) bestimmt wird.

13. Computerprogrammprodukt mit Programmcodemitteln, welche eine elektronische Recheneinrichtung (16) dazu veranlassen, wenn die Programmcodemittel von der elektronischen Recheneinrichtung (16) abgearbeitet werden, ein Verfahren nach einem der Ansprüche 1 bis 12 durchzuführen.

14. Computerlesbares Speichermedium mit einem Computerprogrammprodukt nach Anspruch 13.

15. Messvorrichtung (10) zum Bestimmen einer eine Batteriezelle (12) charakterisierenden Eigenschaft, mit zumindest einem Zyklisierer (14), einer elektronischen Recheneinrichtung (16) und einer Schalteinrichtung (18), wobei die Messvorrichtung zum Durchführen eines Verfahrens nach einem der Ansprüche 1 bis 12 ausgebildet ist.

FIG 1
12
12
18
18
14
14
16
16
10
10

FIG 2
20
22
20
V
$V_{max}$
$V_{min}$
t
24
24
24
I
$I_{HPC}$
t
20
22
20
20
22
20
Q
28
28
26
28
$Q_{charge}$
$Q_{discharge}$
t
26
26
$t_{charge}$
$t_{discharge}$

# EUROPÄISCHER RECHERCHENBERICHT

Nummer der Anmeldung
EP 24 16 5969

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2022 201676 B4 (SIEMENS AG [DE]) 31. August 2023 (2023-08-31) * Absätze [0006] - [0007], [0018] - [0032]; Abbildungen 1, 2 * | 1-15 | INV. G01R31/3832 G01R31/385 G01R31/392 |
| X | US 10 705 152 B1 (WEISS STEVEN E [US] ET AL) 7. Juli 2020 (2020-07-07) * Abbildung 4B * * Spalte 2, Zeilen 27-64 * * Spalte 3, Zeilen 38-46 * * Spalte 3, Zeile 66 - Spalte 4, Zeile 7 * * Spalte 11, Zeilen 35-45 * * Spalte 18, Zeilen 1-17 * * Spalte 18, Zeilen 29-31 * * Spalte 21, Zeilen 17-49 * * Spalte 23, Zeilen 34-40 * | 1-15 | |
| A | US 3 526 822 A (DICKFELDT SIEGFRIED ET AL) 1. September 1970 (1970-09-01) * das ganze Dokument * | 1-15 | |
| | | | RECHERCHIERTE SACHGEBIETE (IPC) |
| | | | G01R |

Der vorliegende Recherchenbericht wurde für alle Patentansprüche erstellt

| Recherchenort | Abschlußdatum der Recherche | Prüfer |
|---|---|---|
| München | 19. September 2024 | Jedlicska, István |

2

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 24 16 5969

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-09-2024

| Im Recherchenbericht angeführtes Patentdokument | Datum der Veröffentlichung | Mitglied(er) der Patentfamilie | Datum der Veröffentlichung |
|---|---|---|---|
| DE 102022201676 B4 | 31-08-2023 | DE 102022201676 A1 | 17-08-2023 |
| | | WO 2023156520 A1 | 24-08-2023 |
| US 10705152 B1 | 07-07-2020 | KEINE | |
| US 3526822 A | 01-09-1970 | DE 1496344 A1 | 10-04-1969 |
| | | FR 1562770 A | 11-04-1969 |
| | | GB 1141518 A | 29-01-1969 |
| | | JP S463222 B1 | 26-01-1971 |
| | | US 3526822 A | 01-09-1970 |

EPO FORM P0461

Für nähere Einzelheiten zu diesem Anhang : siehe Amtsblatt des Europäischen Patentamts, Nr.12/82